# EUROPÄISCHE PATENTSCHRIFT

(11) **EP 3 763 031 B1**
(45) Veröffentlichungstag und Bekanntmachung des Hinweises auf die Patenterteilung: **28.09.2022**
(21) Anmeldenummer: 19710621.4
(22) Anmeldetag: 01.03.2019
(51) Int. Cl.: G01R 31/327, H02P 13/06

(54) **SYSTEM, VERFAHREN UND COMPUTERPROGRAMMPRODUKT ZUR ERFASSUNG PHYSIKALISCHER GRÖSSEN VON MINDESTENS EINER KOMPONENTE EINES STUFENTRANSFORMATORS UND ZUM MONITORING DER KOMPONENTEN EINES STUFENTRANSFORMATORS**
SYSTEM, METHOD AND COMPUTER PROGRAMME PRODUCT FOR DETECTING PHYSICAL VARIABLES OF AT LEAST ONE COMPONENT OF A TAP-CHANGING TRANSFORMER AND FOR MONITORING THE COMPONENTS OF A TAP-CHANGING TRANSFORMER
SYSTÈME, PROCÉDÉ ET PROGRAMME INFORMATIQUE POUR LA DÉTECTION DE GRANDEURS PHYSIQUES D'AU MOINS UN COMPOSANT D'UN TRANSFORMATEUR À CHANGEMENT DE PRISES ET POUR LA SURVEILLANCE DES COMPOSANTS D'UN TRANSFORMATEUR À CHANGEMENT DE PRISES

(30) Priorität: 06.03.2018 DE 102018105087
(43) Veröffentlichungstag der Anmeldung: 13.01.2021
(73) Patentinhaber: Maschinenfabrik Reinhausen GmbH, 93059 Regensburg (DE)
(72) Erfinder: SAVELIEV, Anatoli, 93197 Zeitlarn (DE); VIERECK, Karsten, 93049 Regensburg (DE)
(86) Internationale Anmeldenummer: PCT/EP2019/055193
(87) Internationale Veröffentlichungsnummer: WO 2019/170554

(56) Entgegenhaltungen:
- CN-A- 107 016 352
- CN-A- 107 356 869
- US-A1- 2017 093 160
- US-B1- 6 215 408
- RIVAS E ET AL: "Condition Assessment of Power OLTC by Vibration Analysis Using Wavelet Transform", IEEE TRANSACTIONS ON POWER DELIVERY, IEEE SERVICE CENTER, NEW YORK, NY, US, Bd. 24, Nr. 2, 1. April 2009 (2009-04-01), Seiten 687-694, XP011253870, ISSN: 0885-8977
- PENGJU KANG ET AL: "Condition Assessment of Power Transformer On-Load Tap-Changers Using Wavelet Analysis", IEEE TRANSACTIONS ON POWER DELIVERY, IEEE SERVICE CENTER, NEW YORK, NY, US, Bd. 16, Nr. 3, 1. Juli 2001 (2001-07-01), XP011050063, ISSN: 0885-8977, DOI: 10.1109/61.924817
- SEO JUNHYUCK ET AL: "On Savitzky-Golay Filtering for Online Condition Monitoring of Transformer On-Load Tap Changer", IEEE TRANSACTIONS ON POWER DELIVERY, IEEE SERVICE CENTER, NEW YORK, NY, US, Bd. 33, Nr. 4, 1. August 2018 (2018-08-01) , Seiten 1689-1698, XP011683174, ISSN: 0885-8977, DOI: 10.1109/TPWRD.2017.2749374 [gefunden am 2018-05-09]

## Beschreibung

Die vorliegende Erfindung betrifft ein System zur Erfassung physikalischer Größen von mindestens einer Komponente eines Stufentransformators und zum Monitoring von mindestens einer Komponente eines Stufentransformators. Mindestens ein Sensor dient zur Erfassung mindestens einer physikalischen Größe von der mindestens einen Komponente des Stufentransformators. Ein Rechner ist mit einem Messgerät kommunikativ verbunden, das selbst mit dem mindestens einen Sensor zum Empfang der mindestens einen physikalischen Größe der mindestens einen Komponente des Stufentransformators kommunikativ verbunden ist. Ferner betrifft die Erfindung ein Verfahren zum Monitoring von mindestens einer Komponente eines Stufentransformators. Mindestens ein Sensor wird zur Erfassung physikalischer Größen als Funktion der Zeit vorgesehen.

Ebenso betrifft die Erfindung ein Computerprogrammprodukt zum Monitoring von mindestens einer Komponente eines Stufentransformators.

### Gebiet der Erfindung

Laststufenschalter (im Englischen "on-load tap-changers", abgekürzt OLTC) sind im Stand der Technik allseits bekannt und gebräuchlich. Sie dienen zur unterbrechungslosen Umschaltung zwischen verschiedenen Wicklungsanzapfungen von Stufentransformatoren. In dem Artikel von E. Rivas, J. C. Burgos and J. C. Garcia-Prada, "Condition Assessment of Power OLTC by Vibration Analysis Using Wavelet Transform," in IEEE Transactions on Power Delivery, vol. 24, no. 2, pp. 687-694, April 2009, wird eine Überwachung eines Stufentransformators offenbart.

Die europäische Patentschrift EP 2 409 398 B1 offenbart eine Einrichtung zur Überwachung von Stufenschaltern für Transformatoren. Durch Messung mindestens eines geeigneten Kontrollparameters, wie z.B. Motorstrom, Motorspannung, Drehmoment, Motorgeräusche, Temperatur und der Schaltgeräusche des Stufenschalters, werden Daten für die Überwachung gewonnen. Die Einrichtung verfügt über Mittel, mit welchen Start-Werte mindestens eines Kontrollparameters als Referenzwert hinterlegbar sind. Ferner sind Mittel vorgesehen, um diese Werte mit aktuellen Betriebs-Ist-Werten zu vergleichen und die daraus erzeugten Datensätze werden einer Auswerteinheit zugeführt. Ein zu verwendender Stufenschalter, dessen Funktion als geeignet erachtet wird, also frei von Defekten ist, wird zum Einlernen verwendet. In einem ersten Betrieb dieses Schalters werden verschiedene Betriebszustände abgearbeitet und Referenzwerte ermittelt. Diese ermittelten Referenzwerte werden in einer Speichereinheit hinterlegt. Gemäß einer Funktion ist vorgesehen, dass mit dem Schwingungsaufnehmer bzw. Mikrofon möglichst die Motorgeräusche erfasst werden, während ein anderes Erfassungsmittel so angebracht wird, dass es praktisch nur das Schaltgeräusch aufnimmt und vom Motorengeräusch wenig beeinflusst wird. Dann kommt für die Motorgeräusche eine Frequenzanalyse in Betracht, während die Schaltgeräusche mittels eines Ereignisdetektors analysiert werden.

Das US Patent US 6,215,408 B1 offenbart ein Verfahren und eine Vorrichtung zum Verarbeiten von vibroakustischen Signalen, die von einem Hochspannungsumschaltsystem ausgesendet werden. Das analoge, vibroakustische Signal wird in ein digitales Signal gewandelt. Das digitale Signal wird nach einer Verbesserung mit einem konventionellen Filter geglättet und nachher reduziert. Eine Neuausrichtung des geglätteten Signals bezüglich einer Referenzsignatur wird durchgeführt, um ein neu ausgerichtetes Signal zu erhalten. Werte der Zeitabweichung erzeugen einen Alarm, falls sie einen Grenzwert überschreiten. Aus dem neu ausgerichteten Signal wird eine neue Referenz erzeugt, die eine aktualisierte Signatur darstellt Das neu ausgerichtete Signal wird mit den aktualisierten Signaturen und den Referenzsignaturen verglichen, um ein schrittweises Änderungsverhalten oder eine plötzliche Änderung zu detektieren, wobei hierzu Varianzen mit einbezogen werden.

Es ist daher Aufgabe der Erfindung, ein System zur Erfassung physikalischer Größen von mindestens einer Komponente eines Stufentransformators und zum Monitoring der mindestens einen Komponente des Stufentransformators bereitzustellen, das robust ist und durch eine Dynamik der ermittelten Grenzwerte eine zuverlässige Detektion eines Fehlers bei der Lastumschaltung ermöglicht.

Diese Aufgabe wird durch ein System zur Erfassung physikalischer Größen von mindestens einer Komponente eines Stufentransformators und zum Monitoring der mindestens einen Komponente des Stufentransformators gelöst, das die Merkmale des Anspruchs 1 umfasst.

Eine weitere Aufgabe der Erfindung ist, ein Verfahren zum Monitoring von mindestens einer Komponenten eines Stufentransformators bereitzustellen, das robust ist und eine dynamische Anpassung der ermittelten Grenzwerte ermöglicht, was zu einer zuverlässigen Detektion eines Fehlers bei der mindestens einen Komponente führt.

Diese Aufgabe wird durch ein Verfahren zum Monitoring von mindestens einer Komponente eines Stufentransformators gelöst, das die Merkmale des Anspruchs 4 umfasst.

Hinzu kommt noch die weitere Aufgabe der Erfindung, ein Computerprogrammprodukt zum Monitoring von mindestens einer Komponente eines Stufentransformators bereitzustellen, das robust ist und durch eine dynamische Anpassung der ermittelten Grenzwerte ermöglicht, was zu einer zuverlässigen Detektion eines Fehlers der mindestens einen Komponente führt.

Diese Aufgabe wird durch ein Computerprogrammprodukt zum Monitoring von Komponenten eines Stufentransformators gelöst, das die Merkmale des Anspruchs 10 umfasst.

Das erfindungsgemäße System zur Erfassung physikalischer Größen von mindestens einer Komponente eines Stufentransformators und zum Monitoring der mindestens einen Komponente eines Stufentransformators ist mit mindestens einem Sensor zur Erfassung der physikalischen Größen von der mindestens einen Komponente des Stufentransformators versehen. Ein Rechner ist kommunikativ mit einem Messgerät verbunden, das mit dem mindestens einen Sensor zum Empfang der physikalischen Größen der mindestens einen Komponente des Stufentransformators kommunikativ verbunden ist. Das System umfasst einen Aufnahmebereich, der zum Empfang der im Messgerät gesammelten physikalischen Größen als Funktion der Zeit des mindestens einen Sensors ausgebildet ist. In einem Datenaufbereitungsbereich wird eine Filterung der physikalischen Größen als Funktion der Zeit der mindestens einen Komponente des Stufentransformators (3) durchgeführt. Aus den gefilterten Signalen wird eine hochaufgelöste Hüllkurve erstellt, die einen Signalpegel der physikalischen Größe der mindestens einen Komponente darstellt. In einem Datenanalysebereich wird eine erste Grenzwertkurve und eine zweite Grenzwertkurve bestimmt, deren Lage in Richtung einer Ordinate veränderbar ist und die erste Grenzwertkurve einen Grenzwert darstellt.

Mit dem erfindungsgemäßen System kann eine Vielzahl von Komponenten eines Stufentransformators überwacht werden. Die Komponenten des Stufentransformators sind z.B. ein Laststufenschalter, der Wähler, der Motorantrieb des Laststufenschalters, Lüfter, und Lüftermotoren, die dem Stufentransformator zugeordnet sind, das Transformatorgehäuse, oder das Öl im Transformatorgehäuse.

Ohne als Beschränkung der Erfindung aufgefasst zu werden, kann die mindestens eine Komponente ein Laststufenschalter mit einem Motorantrieb sein. Der Motorantrieb dient zur Einstellung verschiedener Schaltpositionen des Laststufenschalters. Der mindestens eine Sensor dient zur Erfassung der beim Schaltvorgang eines Laststufenschalters verursachten mechanischen Schwingungen, Der mindestens eine Sensor muss dabei nicht zwingend am Laststufenschalter angebracht sein.

Für die Aufnahme des Körperschalls kann z.B. ein Sensor ausreichen, der in Form eines Beschleunigungssensors ausgebildet ist.

Das erfindungsgemäße System hat den Vorteil, dass eine hochmoderne Automatisierungsplattform vorgesehen ist, die für die Erfassung und Auswertung aller relevanten Betriebsdaten eines Stufentransformators einsetzbar ist. So lassen sich Betrieb, Wartung und Austausch von Betriebsmitteln des Stufentransformators effizienter und zielgerichteter planen. Aus den mit dem mindestens einen Sensor gewonnenen Daten kann der Stufentransformator zuverlässig überwacht werden.

Bei dem erfindungsgemäßen Verfahren zum Monitoring von mindestens einer Komponente eines Stufentransformators. ist mindestens ein Sensor im oder am Stutentransformator vorgesehen, wobei der mindestens eine Sensor zur Erfassung physikalischer Größen als Funktion der Zeit dient.

Zunächst werden die physikalischen Größen von dem mindestens einen Sensor von einem Messgerät erfasst. Vom Messgerät werden die aufgenommenen analogen, physikalischen Größen an einen Aufnahmebereich eines Rechners übertragen. In einem Datenaufbereitungsbereich werden die erfassten physikalischen Größen gefiltert und in eine digitale, hochaufgelöste Hüllkurve umgewandelt. Aus der hochaufgelösten Hüllkurve wird mittels Datenreduktion eine Hüllkurve gewonnen.

In einem Datenanalysebereich werden anhand der Hüllkurve für jede physikalische Größe eine erste Grenzwertkurve und eine zweite Grenzwertkurve ermittelt. Die erste Grenzwertkurve und die zweite Grenzwertkurve werden aufgrund von Hüllkurven für nachfolgend gemessene physikalische Größen anhand der ersten Grenzwertkurve und der zweiten Grenzwertkurve für vorausgehende gemessene physikalische aktualisiert. Die erste Grenzwertkurve stellt einen Grenzwert dar.

Das aufgezeichnete Signal der gemessenen physikalischen Größe der mindestens einen Komponente des Stufentransformators wird einer Filterung unterzogen. Die gefilterten physikalischen Größen werden in digitale Daten umgewandelt. Gemäß einer bevorzugten Ausführungsform des erfindungsgemäßen Verfahrens ist die Filterung eine Tiefpassfilterung der aufgezeichneten physikalischen Größen, was zur Vermeidung von Alias-Effekten dient. Die gefilterten physikalischen Größen werden in digitale Signale umgewandelt, die eine hochaufgelöste Hüllkurve ergeben. Auf die hochaufgelöste Hüllkurve wird eine erneute Tiefpassfilterung angewendet und das gefilterte digitale Signal wird einer Datenreduzierung unterzogen.

Die Ermittlung der Hüllkurve wird anhand einer Vielzahl von Stützstellen durchgeführt, die auf Basis der hochaufgelösten Hüllkurve bestimmt werden. Vor der Bestimmung der ersten und der zweiten Grenzwertkurve wird die Hüllkurve dadurch ausgebereitet, dass in jede Stützstelle eine Funktion gesetzt wird. Bevorzugt wird in jede Stützstelle der Hüllkurve eine nach unten geöffnete unsymmetrische Funktion gesetzt. Insbesondere kann die Funktion eine nach unten geöffnete Parabel sein Eine weitere mögliche Eigenschaft der Parabel kann sein, dass sie links schmäler ist als rechts. Die Verwendung einer Parabel soll nicht als eine Beschränkung der Erfindung ausgefasst werden. Es können auch andere Funktionen, wie z.B. unsymmetrische Funktionen an den Stützstellen eingesetzt werden.

Nach dem Ausbreiten der Hüllkurve wird eine neue Berechnung der zweiten Grenzwertkurve durchgeführt. Mit der neu berechneten zweiten Grenzwertkurve kann dann eine Aktualisierung der beiden Grenzwertkurven durchgeführt werden. Ebenso besteht die Möglichkeit, dass das nicht jede Hüllkurve in die Berechnung der zweiten Grenzwertkurve einbezogen wird. Dies ist zum Beispiel dann der Fall, wenn plötzlich ein einmaliges Ereignis in der Hüllkurve entdeckt wird. Sollte dieses Ereignis mehrfach hintereinander auftreten, wird die Hüllkurve in die Berechnung der zweiten Grenzwertkurve einbezogen und gegebenenfalls ein Alarm für eine Fehlfunktion abgesetzt.

Gemäß einer bevorzugten Ausführungsform, ohne als Beschränkung aufgefasst zu werden, der Erfindung ist die mindestens eine Komponente des Stufentransformators ein Laststufenschalter. Der Laststufenschalter dient zur Einstellung verschiedener Schaltpositionen des Stufentransformators. Hierzu sind dem Stufentransformator ein Motorantrieb zum Antrieb des Laststufenschalters und mindestens ein Sensor zur Erfassung der von einem Schaltvorgang des Laststufenschalters verursachten mechanischen Schwingungen zugeordnet. Die Anordnung der Sensoren kann an beliebigen Stellen des Laststufenschalters bzw. des Stufentransformators erfolgen

Der mindestens eine Sensor kann zur Erfassung mechanischen Schwingungen ein Beschleunigungssensor sein. Der Beschleunigungssensor zeichnet den durch einen Schaltvorgang des Laststufenschalters verursachte Körperschallsignal als Funktion der Zeit auf.

Der Vorteil des Verfahrens ist, dass damit alle relevanten Betriebsdaten eines Stufentransformators erfasst werden können. So lassen sich Betrieb, Wartung und Austausch von Betriebsmitteln des Stufentransformators effizienter und zielgerichteter planen. Aus den mit dem mindestens einen Sensor gewonnenen Daten kann der Stufentransformator zuverlässig überwacht und die ermittelten Grenzwerte dynamisch eingestellt werden.

Ebenso kann die erfindungsgemäße Idee durch ein Computerprogramprodukt realisiert werden, das eine Vielzahl von Programmanweisungen umfasst, die bei Ausführung der Programmanweisungen durch einen Rechner, den Rechner veranlassen, die Schritte des erfindungsgemäßen Verfahrens auszuführen.

Bevorzugt kann das erfindungsgemäße Verfahren zur Überwachung von Laststufenschalter eines Stufentransformators eingesetzt werden. Ein Laststufenschalter erzeugt bei einem Schaltvorgang charakteristische Schallsignaturen, die z.B. über Beschleunigungssensoren aufgezeichnet und von einem Rechner ausgewertet werden können. Jedoch überlagern sich im Fall der Aufzeichnung des Körperschalls zusätzlich z.B. die Geräusche des Aktivteils und der Kühlanlage des Stufentransformators mit denen des schaltenden Laststufenschalters. Bei einem Laststufenschalter sind die individuellen Schallsignaturen des Lastumschalters bestimmend für den Typ des Stufenschalters. In ihrem zeitlichen Ablauf und Amplitude charakterisieren sie den mechanischen Betriebszustand des jeweiligen Laststufenschalters.

Gemäß einer möglichen Ausführungsform kann der Beschleunigungssensor am Kopf des Laststufenschalters angebracht sein. Auch andere Anbringungsorte, wie z.B. am Transformatorgehäuse oder innerhalb des Transformatorgehäusess sind möglich. Die hohe Auflösung des Schallsignals durch den Beschleunigungssensor bedingt bei nachfolgender analog / digital - Umsetzung im System ein entsprechend hohes Datenvolumen. Dieser Datensatz kann neben dem Geräusch des Stufenschalters vor und nach einer Schaltung auch das Geräusch des Aktivteiles des Stufentransformators mit Grund- und Oberwellen abbilden. Aus den hochfrequenten Anteilen des Datensatzes wird eine Hüllkurve erstellt. Die bekannten unterschiedlichen Schaltungsarten des Laststufenschalters, wie z.B. Umkehrschaltungen (von einer Ausgangsstufe auf eine Stufe und zurück auf die Ausgangsstufe), Vorwählerschaltungen, oder Schaltungen in die Endposition des Laststufenschalters, können unterschiedliche aussehende Hüllkurven erzeugen.

Das erfindungsgemäße, vibroakustische Verfahren, stellt dabei ein pragmatisch, arbeitendes Verfahren mit niedriger Auflösung dar und wird im Folgenden auch als Trackingverfahren bezeichnet.

Dabei wird jede Schaltung des Laststufenschalters dahingehend geprüft, ob sie zu dem gespeicherten historischen Datensatz passt. Bei dem erfindungsgemäßen System der akustischen Überwachung wurde gleichzeitig ein selbstlernender Algorithmus angewendet. Mit der Erfindung wird ein "lernendes" System bzw. "lernendes" Verfahren geschaffen: Im Datensatz der ersten und zweiten Grenzwertkurven handelt sich nicht nur um einmalig gespeicherte Daten. Die erste und zweite Grenzwertkurve werden kontinuierlich anhand einer Vielzahl an vorangegangenen Schaltungen des Laststufenschalters ermittelt. Die erste und zweite Grenzwertkurve beinhalten historische Datensätze, die zusätzlich gewichtet werden können. Erst nach einer gewissen Zahl von Schaltungen (Ereignissen) wird für die Ermittlung des Grenzwerts die erste und zweite Grenzwertkurve bestimmt.

Die Messwerte werden bei jedem Schalten des Laststufenschalters aufgezeichnet. Für die Bewertung der Schaltungen des Laststufenschalters wird bei der Signalaufbereitung der signifikante Teil des Datensatzes zur Erzeugung von Hüllkurven auf etwa einhundert Stützstellen reduziert. Die Anzahl der Stutzstellen soll nicht als Beschränkung der Erfindung aufgefasst werden. So kann z.B. nach Rechenleistung des Rechners die Anzahl der Stützstellen variieren.

Unter der Annahme einer Gaußschen Wahrscheinlichkeitsverteilung werden nachfolgend die signifikanten Peaks der aufgezeichneten Hüllkurven aufgeweitet. Die Hüllkurve wird noch auf Plausibilität geprüft und gegebenenfalls nicht in die Berechnung der ersten und zweiten Grenzwertkurven aufgenommen. Im Ergebnis mit historischen Daten, der Aufweitung der Hüllkurve und/oder einer Verschiebung auf der Ordinate und unter der Berücksichtigung mit der Statistik der vorangegangenen Schaltungen entsteht eine erste Grenzwertkurve über den die Stufenschalterschaltung charakterisierenden Peaks der Hüllkurve des akustischen Schallsignals. Ein singulärer Ausreißer wird somit nicht in die Berechnung der Grenzwertkurven aufgenommen.

Gleichzeitig wird aus der Statistik heraus eine darüber liegende zweite Grenzwertkurve erzeugt, die einen noch höheren Grenzwert für das akustische Signal darstellt.

Die erste und die zweite Grenzwertkurve werden anhand der gespeicherten historischen Daten vom System selbständig ermittelt. Dazu werden statistische Verfahren angewendet.

Nachfolgend sind die Erfindung und ihre Vorteile unter Bezugnahme auf die beigefügten Zeichnungen ausführlicher beschrieben. Es zeigen:
**Fig. 1** eine schematische Ansicht einer Ausführungsform des erfindungsgemäßen Systems zum Monitoring von Komponenten eines Stufentransformators;
**Fig. 2** eine schematische Ansicht einer weiteren Ausführungsform des erfindungsgemäßen Systems zum Monitoring von Komponenten eines Stufentransformators;
**Fig. 3** eine schematische Ansicht des beim erfindungsgemäßen System verwendeten Rechners;
**Fig. 4** eine graphische Darstellung des aufgezeichneten Signals der Vibrationen bei einer durch den Stufenschalter ausgeführten Umschaltung des Stufentransformators von einer aktuellen Anzapfung auf eine benachbarte Anzapfung und einer daraus erzeugten Hüllkurve;
**Fig. 5** eine graphische Darstellung einer vereinfachten Form der in Figur 4 dargestellten Hüllkurve, die beispielhaft aus fünfzig Stützstellen gebildet ist;
**Fig. 6** eine graphische Darstellung einer möglichen Ausführungsform einer Funktion die für die Erweiterung (Ausbreiten) der Hüllkurve aus Figur 5 verwendet werden kann;
**Fig. 7** eine graphische Darstellung der Anwendung der Funktion aus Figur 6 auf einige der Stützstellen der Hüllkurve aus Figur 5;
**Fig. 8** eine graphische Darstellung der Anwendung der Funktion aus Figur 6 auf alle Stützstellen der Hüllkurve aus Figur 5 und zur Ermittlung einer erweiterten Hüllkurve;
**Fig. 9** eine Wiedergabe einer Tracking-Analyse des Schaltgeräusches eines im Betrieb befindlichen Stufenschalters auf einem Monitor;
**Fig.10** eine Darstellung des Ergebnisses der Tracking-Analyse des Schaltgeräusches eines der Stufenschalter auf einem dem Stufentransformator zugeordneten Display; und
**Fig. 11** ein Flussdiagramm des erfindungsgemäßen Verfahrens.

Für gleiche oder gleich wirkende Elemente der Erfindung werden identische Bezugszeichen verwendet. Ferner werden der Übersicht halber nur Bezugszeichen in den einzelnen Figuren dargestellt, die für die Beschreibung der jeweiligen Figur erforderlich sind. Die dargestellten Ausführungsformen stellen lediglich Beispiele dar, wie das erfindungsgemäße System, das erfindungsgemäße Verfahren oder das erfindungsgemäße Computerprogrammprodukt ausgestaltet sein können.

Die nachfolgende Beschreibung bezieht sich aus ein System und ein Verfahren zur Erfassung von Körperschall eines Laststufenschalters eines Stufentransformators. Die Beschränkung der nachfolgenden Beschreibung auf die Bestimmung von Grenzwertkurven aus dem gemessenen Körperschall eines Laststufenschalters soll nicht als Beschränkung der Erfindung aufgefasst werden. Es ist für einen Fachmann selbstverständlich, dass mit erfindungsgemäßen Verfahren eine Vielzahl von unterschiedlichen Komponenten eines Stufentransformators überwacht werden können.

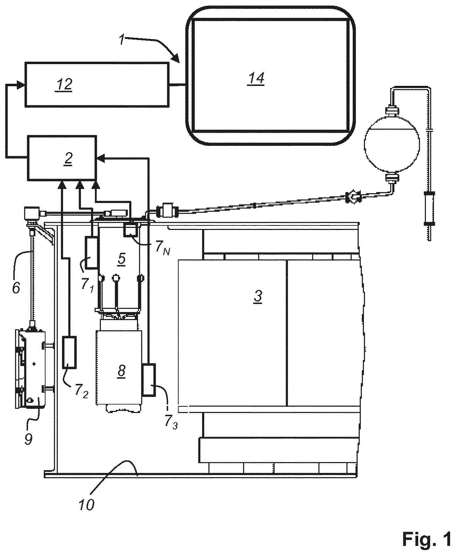

**Figur 1** zeigt eine schematische Ansicht einer Ausführungsform des erfindungsgemäßen Systems 1 zum Monitoring von Komponenten eines Stufentransformators 3. Der Stufentransformator 3 ist von einem Transformatorgehäuse 10 umgeben. Mit einem Laststufenschalter 5 können die verschiedenen Wicklungsanzapfungen (nicht dargestellt) des Stufentransformators 3 beschaltet werden. Um eine ordnungsgemäße Funktionsweise des Stufentransformators 3 gewährleisten zu können, muss der Laststufenschalter 5 den erforderlichen Schaltablauf ohne Störungen ausführen. Um Alterungsvorgänge des Laststufenschalters 5 und/oder des Stufentransformators 3 möglichst frühzeitig zu erkennen und ggf. Servicemaßnahmen einleiten zu können, ist mindestens ein Sensor 7₁, 7₂, 7₃,..., 7N vorgesehen, der die vibroakustischen Schwingungen des Laststufenschalters 5 aufgrund der Schaltvorgänge erfasst. Der Laststufenschalter 5 ragt in das Transformatorgehäuse 10 hinein, das je nach Typ des Stufentransformators 3 mit Öl gefüllt sein kann. Der mindestens eine Sensor 7₁, 7₂,..., 7_{N} kann dem Laststufenschalter 5, dessen Wähler 8 und/oder einem Motorantrieb 9 zugeordnet sein. Der mindestens eine Sensor 7₁, 7₂,..., 7_{N} ist im Allgemeinen als Schall-/ Vibrationsaufnehmer, wie z.B. Hydrophon in Öl, Mikrophon, Piezoscheibe in Öl, Beschleunigungssensor bzw. Vibrationssensor, ausgestaltet. Bei der hier dargestellten Ausführungsform wird die Antriebsbewegung des Motorantriebs 9 über ein Gestänge 6 an den Laststufenschalter 5 bzw. den zugeordneten Wähler 8 übertragen. Der mindestens eine Sensor 7₁, 7₂,..., 7_{N} ist mit einem Messgerät 2 verbunden, das die Signale der Sensoren 7₁, 7₂,..., 7N sammelt.

Die von dem mindestens einen Sensor 7₁, 7₂, ..., 7_{N} aufgenommenen Signale werden über das Messgerät 2 an einen Rechner 12 übergeben. Die Signale können dort ver- und bearbeitet werden. Der Rechner 12 ist bei der in Figur 1 dargestellten Ausführungsform örtlich dem Transformatorgehäuse 10 zugeordnet.

Ebenso ist es denkbar, dass die Signale von dem mindestens einen Sensor 7₁, 7₂, ,..., 7_{N} an den Rechner 12 gesendet werden, wobei hierzu alle gängigen Übertragungsmöglichkeiten vorstellbar sind, so dass die Auswertung der erfassten Signale in einer örtlich entfernten Warte, beispielsweise einer Servicezentrale, (nicht dargestellt) erfolgt. Zur Visualisierung der von dem mindesten einen Sensor 7₁, 7₂, ..., 7_{N} aufgenommenen und mit dem Rechner 12 verarbeiteten Signale ist ein Monitor 14 bzw. Userinterface zugeordnet.

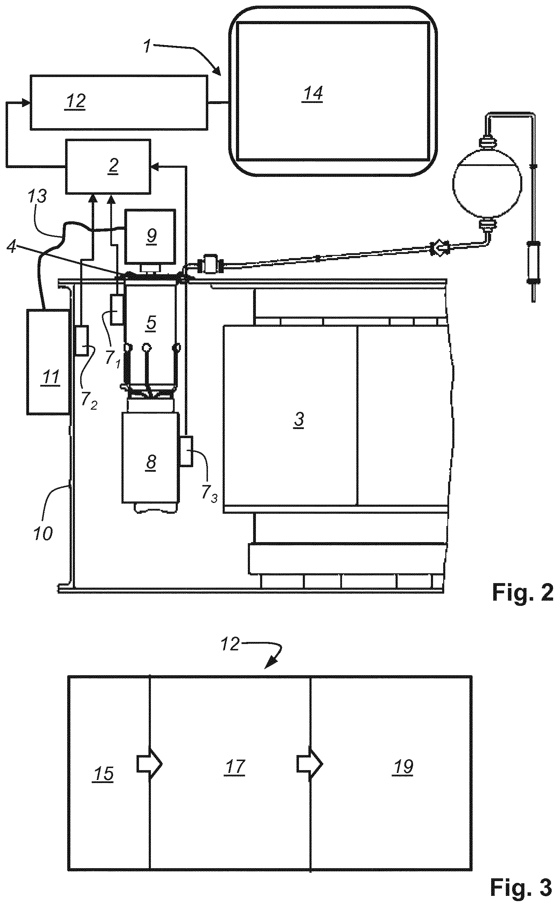

**Figur 2** zeigt eine weitere Ausführungsform der Anordnung des Motorantriebs 9 für den Laststufenschalter 5 bzw. Wähler 8. Der Motorantrieb 9 ist außerhalb des Transformatorgehäuses 10 direkt dem Laststufenschalter 5 zugeordnet. Am Transformatorgehäuse 10 ist eine Ansteuerung 11 für den Motorantrieb 9 vorgesehen. Die Steuersignale von der Ansteuerung 11 werden z.B. über eine Kabelverbindung 13 an den Motorantrieb 9 geleitet. Das System 1 weist mehrere Sensoren 7₁, 7₂,..., 7_{N} auf, die bei der hier dargestellten Ausführungsform z.B. dem Laststufenschalter 5, dem Wähler 8 oder dem Transformatorgehäuse 10 zugeordnet sind. Der mindestens eine Sensor 7₁, 7₂,..., 7_{N} ist kommunikativ mit dem Messgerät 2 verbunden. Von dem Messgerät 2 werden die gemessenen Signale an einen Rechner 12 übergeben. In der Regel ist der Rechner 12 und der Monitor 14 in der Nähe des Transformatorgehäuses 10 angeordnet. Dies soll jedoch in keinster Weise als eine Beschränkung der Erfindung aufgefasst werden.

Wird bei der Auswertung der erfassten Signale bei den Ausführungsformen der Figur 1 oder der Figur 2 eine Abweichung festgestellt, kann über das System eine Alarmmeldung abgesetzt werden. Die Alarmmeldung kann z.B. auf dem Monitor 14 ausgegeben werden. Andere Möglichkeiten der Ausgabe der Warnmeldung sind denkbar.

In **Figur 3** ist schematisch der Aufbau des Rechners 12 dargestellt. Der Rechner umfasst zumindest einen Aufnahmebereich 15, einen Datenaufbereitungsbereich 17 und einen Datenanalysebereich 19. Im Aufnahmebereich 15 werden die von dem mindestens einen Sensor 7₁, 7₂,..., 7_{N} aufgenommenen Signale gesammelt, die mit dem Aufnahmebereich 15 des Rechners 12 kommunikativ verbunden sind. Der mindestens eine Sensor 7₁, 7₂,..., 7_{N} kann z.B. als ein Beschleunigungssensor ausgebildet sein. Von der Messeinheit 15 werden die erfassten Signale an einen Datenaufbereitungsbereich 17 des Rechners 12 übergeben. Zunächst werden die Signale im Datenaufbereitungsbereich 17 empfangen. Die gelieferten Signale (Rohdaten) werden gefiltert und in digitale Daten umgewandelt. Aus den digitalen Daten wird eine Hüllkurve erstellt. Die Hüllkurve ist hochaufgelöst.

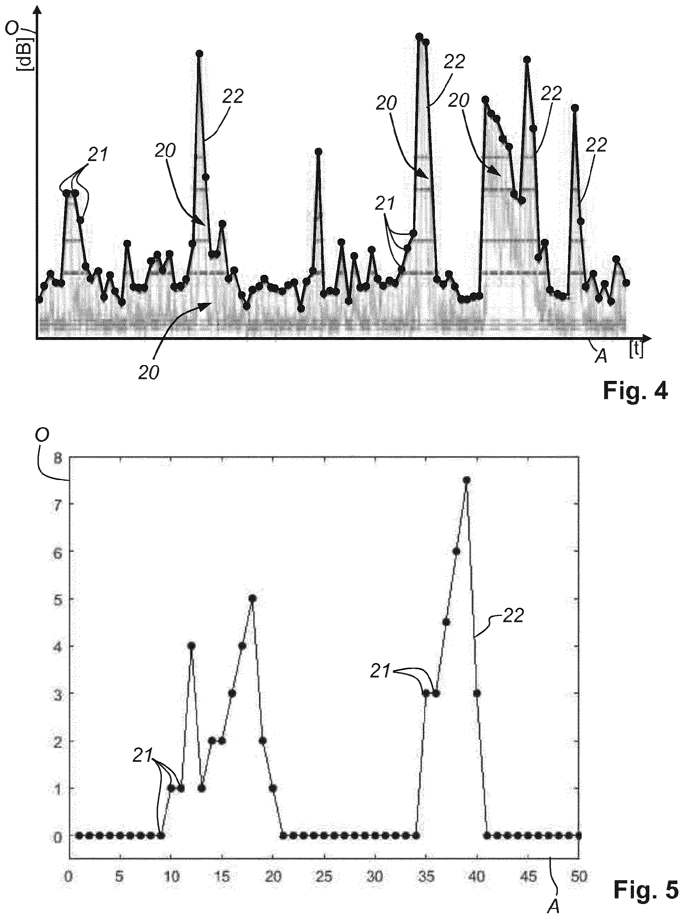

**Figur 4** zeigt eine graphische Darstellung des von dem mindestens einen Sensor 7₁, 7₂,..., 7_{N} aufgezeichneten Signals, das bereits in eine hochaufgelöste Hüllkurve 20 der Vibrationen umgewandelt wurde. Die Vibrationen entstehen bei einer durch den Laststufenschalter 5 ausgeführten Umschaltung des Stufentransformators 3 von einer aktuellen Anzapfung (nicht dargestellt) auf eine benachbarte Anzapfung (nicht dargestellt) und einer aus der hochaufgelösten Hüllkurve 20 erzeugten Hüllkurve 22, die mit reduzierter Anzahl an Messpunkten gebildet wird. Für die Ermittlung der Hüllkurve 22 wird aus der hochaufgelösten Hüllkurve 20 eine Vielzahl von Stützstellen 21 ermittelt, die letztendlich die Hüllkurve 22 bestimmen. Der mindestens eine Sensor 7₁, 7₂,..., 7_{N} zur Aufnahme der Vibrationen (Körperschall) kann z.B. ein Beschleunigungssensor sein. Auf der Abszisse A ist die Zeit in beliebigen Einheiten aufgetragen. Auf der Ordinate O ist die Signalstärke in Dezibel (dB) aufgetragen. Bei jeder Stufenschalterschaltung werden die in Figur 4 gezeigte hochaufgelöste Hüllkurve 20 und die Hüllkurve 22 ermittelt. Dabei wird jede Stufenschalterschaltung dahingehend geprüft, ob sie zu dem gespeicherten historischen Datensatz (erste Grenzwertkurve bzw. zweite Grenzwertkurve) passt. Dabei wird der signifikante Teil eines Datensatzes der hochaufgelösten Hüllkurve 20 zur Erzeugung der Hüllkurve 22 auf etwa einhundert Stützstellen 21 reduziert (wie bereits oben erwähnt soll die Anzahl der Stützstellen 21 nicht als Beschränkung der Erfindung aufgefasst werden.

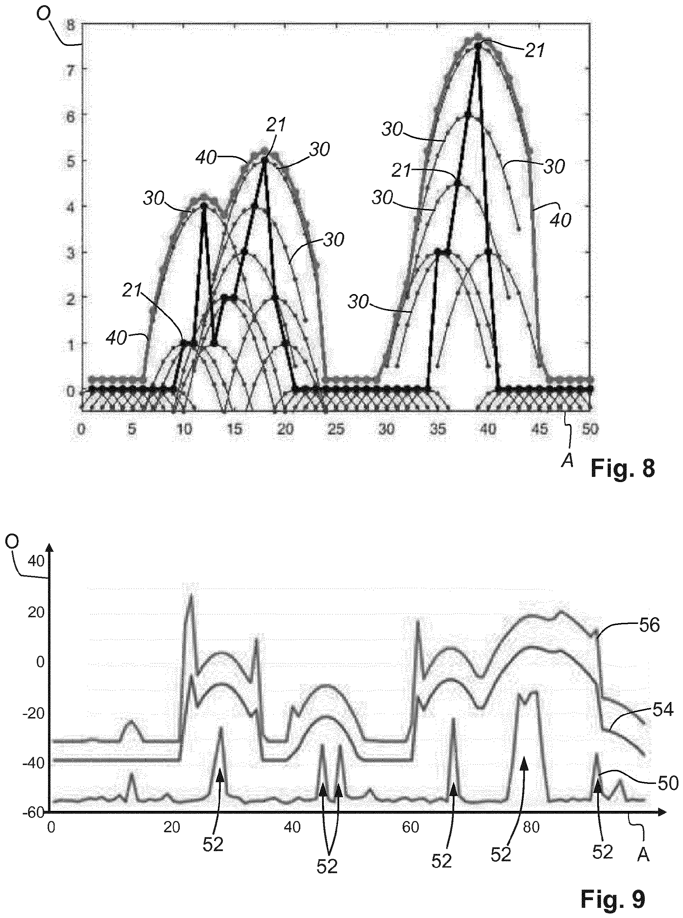

**Figur 5** zeigt eine graphische Darstellung einer vereinfachten Form der in Figur 4 dargestellten Hüllkurve 22. Die Hüllkurve 22 ist im hier dargestellten Beispiel aus fünfzig Stützstellen 21 gebildet und für die Darstellung der Gewinnung der Grenzwertkurven 54, 56 (siehe Figur 8 oder 9) gezeigt. Auf der Abszisse A ist die Zeit und auf der Ordinate O das Signal aufgetragen.

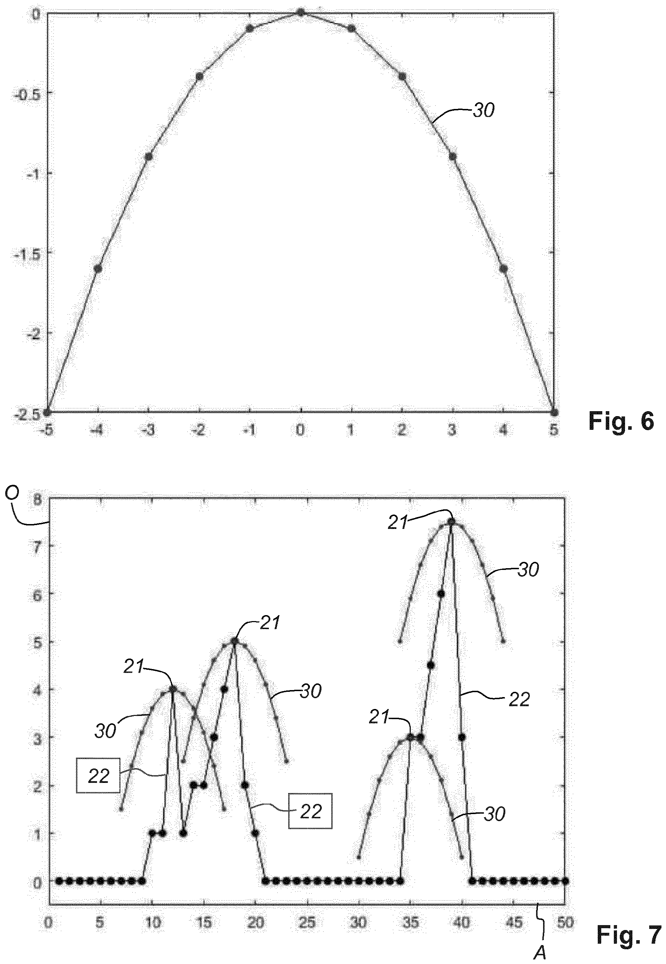

**Figur 6** zeigt eine graphische Darstellung einer möglichen Ausführungsform eine Funktion 30, die für die Erweiterung (Ausbreiten) der Hüllkurve 22 aus Figur 4 verwendet werden kann. Bei der hier dargestellten Ausführungsform ist die Funktion 30 eine Parabel (eine quadratische Funktion, die für die Erweiterung verwendet werden kann). Die Art der Funktion 30 soll nicht als eine Beschränkung der Erfindung aufgefasst werden. Die Anwendung der Funktion (Parabel) aus Figur 5 ist in **Figur 7** dargestellt. Auf einige der Stützstellen 21 der Hüllkurve 22 ist die Funktion 30 gesetzt.

**Figur 8** zeigt eine graphische Darstellung der Anwendung der Funktion 30 aus Figur 5 auf allen Stützstellen 21 der Hüllkurve 22 aus Figur 4. Durch die Anwendung der Funktion 30 auf alle Stützstellen 21 der Hüllkurve 22 erhält man eine resultierende Signalkurve 40. Die resultierende Signalkurve 40 ist etwas in Richtung Ordinate O versetzt, damit die resultierende Signalkurve 40 besser zu erkennen ist. Die resultierende Signalkurve 40 wird zur Ermittlung der Grenzwerte verwendet. Wie bereits erwähnt kann die Form der Funktion 30 von einer quadratischen Funktion abweichen. Dabei ist zu beachten, dass die Funktion 30 mit Berücksichtigung der Signalform und der Art der zu erwartenden Veränderungen ausgewählt werden. Die Form der Funktion 30 kann, aber muss nicht, symmetrisch sein. Ebenso kann die Form der Funktion 30, sowohl von der Zeit als auch von der Signalstärke oder anderen Parametern variabel abhängig, flexibel ausgestatten werden.

**Figur 9** zeigt eine Wiedergabe einer Tracking-Analyse des Schaltgeräusches eines im Betrieb befindlichen Laststufenschalters 5, wie es gemäß **Figur 9** auf einem Monitor 14 dargestellt werden kann.

Dabei wird jeder Schaltablauf des Laststufenschalters 5 dahingehend geprüft, ob er zu den gespeicherten historischen Datensatz passt. Wie bei der Clusteranalyse wird die Datenbasis dafür bei jedem Schaltablauf des Laststufenschalters 5 auf Basis des Signalpegels 50 eines jeden Schaltablaufs des Laststufenschalters 5 geprüft. Der Signalpegel 50 wird aus den Messdaten (Signale) eines Schaltablaufs des Laststufenschalters 5 gewonnen, wobei, wie in Figur 3 beschrieben, die Hüllkurve 22 den Signalpegel 50 repräsentiert. Für die Signalaufbereitung wird der signifikante Teil der Messdaten (Datensatz der Signale) auf etwa einhundert Stützstellen 21 (hier nicht dargestellt) reduziert, um die Hüllkurven bzw. den Signalpegel 50 zu erzeugen.

Der aufgezeichnete und ermittelte Hüllkurve 22 wird zuerst mit der ersten Grenzwertkurve 54 und der zweiten Grenzwertkurve 56 verglichen. Falls die Hüllkurve 22 in Ordnung ist, wird sie (wie in Fig 8 dargestellt ist) aufgeweitet und für die Grenzwertbildung (der ersten und zweiten Grenzwertkurven 54, 56) für die Analyse der nachfolgenden Umschaltungen für jeden Punkt der aufgeweiteten Hüllkurve 22 unter Annahme der Gaußschen Wahrscheinlichkeitsverteilung (die über mehrere Messungen, Umschaltungen, ermittelt wird) miteinbezogen. Im Ergebnis dessen entsteht eine erste Grenzwertkurve 54 über den charakterisierenden Peaks 52 des Signalpegels 50. Gleichzeitig wird aus der Statistik heraus eine darüber liegende zweite Grenzwertkurve 56 erzeugt, die einen höheren Grenzwert für das akustische Signal des Laststufenschalters 5 darstellt. Die aktuell geltenden Grenzwertkurven 54, 56 werden für die Bewertung der aktuell aufgezeichneten physikalischen Größen (hier Körperschall) eingesetzt. Die aktuelle Messung der physikalischen Größen wird nicht für die Grenzwertberechnung einbezogen. Wenn die Messung der physikalischen Größen für gut befunden wurde werden die Grenzwertkurven 54, 56 mit der Berücksichtigung sowohl des aktuellen Hüllkurve 22 auch der vorherigen und bestimmten Grenzwertkurven 54, 56 für die künftigen Messungen der physikalischen Größen umgerechnet.

Die resultierende erste Grenzwertkurve 54 wird als Grenzwert genutzt und gleichzeitig zur flexiblen Anpassung des gerade noch zulässigen Amplitudenbereiches des akustischen Signals herangezogen. Die erste Grenzwertekurve 54 und die zweite Grenzwertekurve 56 werden also nachgezogen. Durch dieses TrackingVerfahren lernt das System während des Schaltens des Laststufenschalters 5 iterativ, wie eine akustische Signatur eines korrekt funktionierenden Laststufenschalters 5 aussieht, um mit dem selbst erzeugten Signalpegel 50 (Hüllkurve 22) alle Folgeschaltungen des Laststufenschalters 5 auf ihren korrekten Ablauf hin zu überprüfen.

Das System zum Monitoring von Komponenten eines Stufentransformators 3 erzeugt zumindest die erste und zweite Grenzwertkurven 54 und 56 für jede Schaltungsart. Somit kann bei jeder neuen Schaltung der Laststufenschalter 5 geprüft werden, ob sich der jeweilige Laststufenschalter 5 hinsichtlich der Amplitude des Schaltgeräusches und des zeitlichen Ablaufes der Schaltung noch im zulässigen Rahmen bewegt. Wird eine Abweichung festgestellt, kann über das System kann eine Alarmmeldung abgesetzt werden.

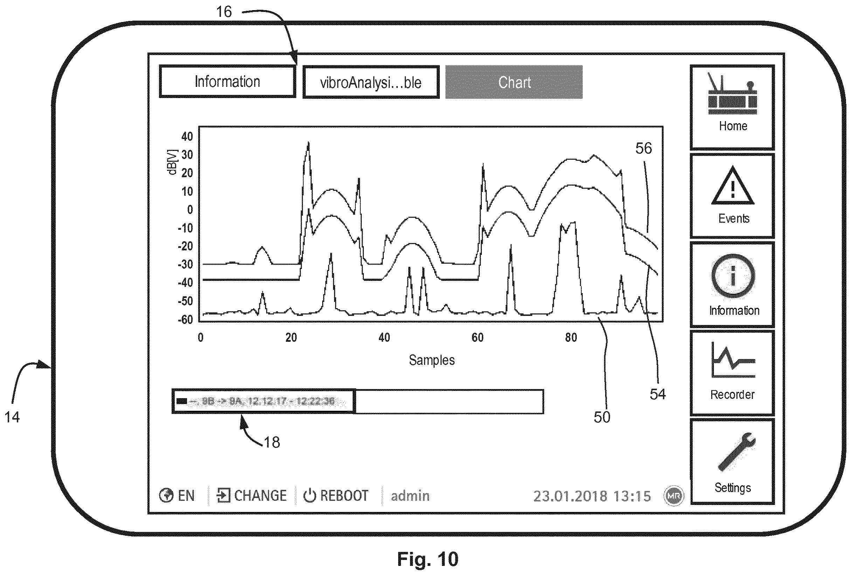

**Figur 10** zeigt eine Darstellung des Ergebnisses (siehe Figur 8) der Tracking-Analyse des Schaltgeräusches des Laststufenschalters 5. Bei dieser Ausführungsform ist der Monitor 14 dem Stufentransformator 3 zugeordnet. Der Monitor 14 umfasst ein Display 16, auf dem die Auswertung des Schaltgeräusches des Laststufenschalters 5 dargestellt werden kann. Auf dem Display 16 ist der in Figur 8 dargestellte und gemessene Signalpegel 50 (in der bearbeiteten Form mit Peaks 52) dargestellt. Ebenfalls sind die aus dem Signalpegel 50 bzw. an Hand des Signalpegels 50 der aus der vorangehenden Schaltung des Laststufenschalters ermittelten Grenzwertkurven 54, 56 dargestellt. Dadurch kann die Historie der vorherigen Schalungen des Laststufenschalters mit in die Berechnung der Grenzwertkurven 54, 56 eingezogen werden. In einem Feld 18 auf dem Display 16 kann einem Benutzer oder Kontrollpersonal die Information gegeben werden, aus welcher Schaltfolge des Laststufenschalters 5 der Signalpegel 50 generiert wurde. Hier wird beispielhaft mittels dem Feld 18 informiert, dass die Umschaltung des Laststufenschalters 5 von der Anzapfung mit der Nr. 9B auf die Anzapfung mit der Nr. 9A erfolgte. Ferner ist auch noch Datum und Uhrzeit der Umschaltung dargestellt. Bei jeder neuen Schaltungsart des Laststufenschalters 5 werden aus dem neu ermittelten Signalpegel 50 die Grenzwertkurven 54, 56 neu erzeugt. Somit lässt sich prüfen, ob sich der jeweilige Laststufenschalter 5 hinsichtlich der Amplitude des Schaltgeräusches und des zeitlichen Ablaufes der Schaltung noch im zulässigen Rahmen bewegt. Die Grenzwertkurven 54, 56 werden anhand der gespeicherten historischen Daten vom System 1 selbständig ermittelt. Dazu werden statistische Verfahren angewendet.

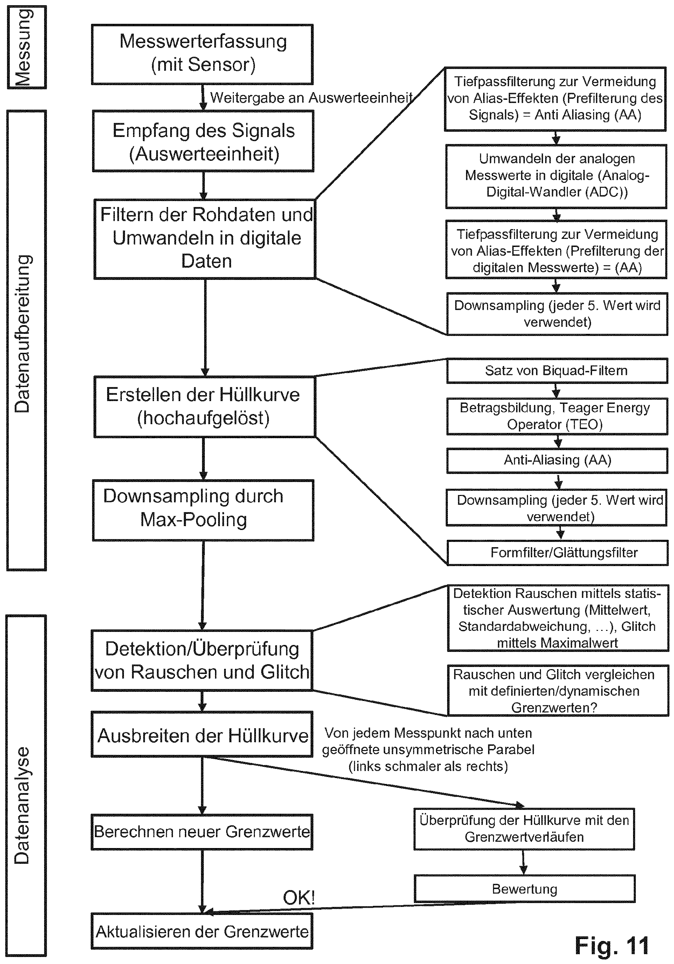

**Figur 11** zeigt ein Flussdiagramm des erfindungsgemäßen Verfahrens zum Monitoring von mindestens einer Komponente eines Stufentransformators. Das erfindungsgemäße Verfahren, wird wie in Figur 2 gezeigt, bei einem System 1 angewendet, das die Antriebsenergie dort zur Verfügung stellt, wo sie gebraucht wird. Bei diesem Ausführungsbeispiel ist der Motorantrieb 9 nämlich auf einem Deckel 4 (dargestellt in Figur 2) des Laststufenschalters 5 vorgesehen. Die Übermittlung der in der Ansteuerung 11 für den Motorantrieb 9 erzeugten Antriebsbefehle erfolgt mittels einer Kabelverbindung 13.

Die Signale bzw die gemessenen physikalischen Größen werden von dem mindestens einen Sensor 7₁, 7₂,..., 7_{N}, automatisch bei einem Schaltvorgang des Laststufenschalters 1 aufgenommen. Die Auswertung und Analyse der Daten ermöglicht eine Monitoringeinheit des Laststufenschalters 5 vor Ort (am Laststufenschalter 5 selbst). Der Rechner 12 und/oder das Display 16 des Monitors 14 können am Transformatorgehäuse 19 des Stufentransformator 3, in einem Schrank am Transformatorgehäuse 19. in einer zentralen Station oder dergleichen untergebracht sein.. Der mindestens eine Sensor 7₁, 7₂,..., 7_{N}, kann als Beschleunigungssensor ausgebildet sein. Die Messwerte (Körperschall) von der Umschaltung des Laststufenschalters werden automatisch von dem Beschleunigungssensor erfasst und über eine kommunikative Verbindung an den Rechner 12 übermittelt. Die erfassten Messwerte werden im Datenaufbereitungsbereich 17 in der erfindungsgemäßen Art und Weise aufbereitet.

Anschließend wird im Datenaufbereitungsbereich 17 eine Filterung der Rohdaten (gemessenen, analogen Signale) vorgenommen. Letztendlich werden die entsprechend bearbeiteten Daten durch einen Analog-Digital-Wandler (nicht dargestellt) des Rechners 12 in digitale Daten gewandelt.

Der Filter des Datenaufbereitungsbereichs 17 umfasst zunächst eine Tiefpassfilterung zur Vermeidung von Alias-Effekten. Dies stellt eine Prefilterung des analogen Signals dar, was ein Anti-Aliasing (AA) oder Kantenglättung bewirkt. Die durch Tiefpassfilterung gefilterten analogen Signale werden mittels eines Analog-DigitalWandlers (ADC) in die digitale, hochaufgelöste Hüllkurve 20 umgewandelt. Auf die hochaufgelöste Hüllkurve 20 wird eine erneute Tiefpassfilterung zur Vermeidung von Alias-Effekten (Prefilterung der digitalen Messwerte) angewendet. Abschließend erfolgt eine Datenreduzierung (Downsampling) des digitalen Signals.

Aus den gefilterten und digitalen Signalen wird eine hochaufgelöste Hüllkurve 20 erstellt. Für jeden Schaltvorgang des Laststufenschalters 5 wird eine entsprechende reduzierte Hüllkurve 22 erzeugt. Zum Erstellen der hochaufgelösten Hüllkurve 20 wird auf die digitalen Signale ein Satz von Biquad-Filtern, eine Betragsbildung ein Anti-Aliasing (AA), ein Downsampling und ein Formfilter/Glättungsfilter angewendet.

Auf die durch die Datenaufbereitung erhaltenen Daten für die hochaufgelöste Hüllkurve 20 wird ein weiteres Downsampling mittels Max-Pooling durchgeführt. Die Hüllkurve 22 ist das Ergebnis.

In Anschluss daran erfolgt eine Datenanalyse in einem Datenanalysebereich 19. Zunächst wird eine Detektion/Überprüfung der Ausläufe der Hüllkurve 22 die Bereiche, vor und nach der Umschaltung des Laststufenschalters, wo normalerweise keine Signale vorhanden sind) bezüglich Rauschen und Glitch überprüft. Das Rauschen wird z.B. mittels statistischer Auswertung (Mittelwert, Standardabweichung, ...) detektiert. Der Glitch wird mittels eines Maximalwerts detektiert. Das detektierte Rauschen und der Glitch werden mit definierten/dynamischen Grenzwerten vergleichen. Zu hohes Rauschen und Werte des Glitch deuten eine äußere Beeinflussung (z.B. Regen, Hagel) an. Bei diesen Bedienungen wird die Analyse des Signals entweder nur eingeschränkt durchgeführt oder ganz auf eine Analyse des Signals verzichtet.

Anschließend wird die Hüllkurve 22 ausgebreitet. Hierzu kann gemäß einer möglichen Ausführungsform, wie bereits erwähnt, in jede Stützstelle 21 (Messpunkt) eine nach unten geöffnete unsymmetrische Funktion 30 gesetzt werden. Diese Funktion 30 kann z.B. eine Parabel sein, die links schmaler als rechts ist.

Nach dem Ausbreiten der Hüllkurve 22 wird damit die Berechnung (Update der Statistik) durchgeführt. Mit den neu berechneten statistischen Daten kann eine Aktualisierung der Grenzwertkurven 54, 56 durchgeführt werden.

Zuerst kann eine Überprüfung der Hüllkurve 22 mit den existierenden Verläufen der Grenzwertkurven 54, 56 durchgeführt werden. Anschließend erfolgt eine Bewertung der Überprüfung und wenn diese für in Ordnung befunden wurde, kann ebenfalls eine Aktualisierung der Grenzwertkurven 54, 56 durchgeführt werden.

### Bezugszeichenliste:

- 1: System
- 2: Messgerät
- 3: Stufentransformator
- 4: Deckel
- 5: Laststufenschalter
- 6: Gestänge
- 7₁, 7₂,..., 7_{N}: Sensor
- 8: Wähler
- 9: Motorantrieb
- 10: Transformatorgehäuse
- 11: Ansteuerung
- 12: Rechner
- 13: Kabelverbindung
- 14: Monitor
- 15: Aufnahmebereich
- 16: Display
- 17: Datenaufbereitungsbereich
- 18: Feld
- 19: Datenanalysebereich
- 20: hochaufgelöste Hüllkurve
- 21: Stützstellen
- 22: Hüllkurve
- 30: Funktion
- 40: resultierende Signalkurve
- 50: Signalpegel
- 52: Peak
- 54: erste Grenzwertkurve
- 56: zweite Grenzwertkurve
- A: Abszisse
- O: Ordinate

## Patentansprüche

1. System (1) zur Erfassung physikalischer Größen von mindestens einer Komponente eines Stufentransformators (3) und zum Monitoring der mindestens einen Komponente des Stufentransformators (3) umfassend: mindestens einen Sensor (7₁, 7₂, ..., 7_{N}) zur Erfassung der physikalischen Größen von der mindestens einen Komponente des Stufentransformators (3) und mit einem Rechner (12), der mit einem Messgerät (2) kommunikativ verbunden ist, das mit dem mindestens einen Sensor (7₁, 7₂, ..., 7_{N}) zum Empfang der physikalischer Größen der mindestens einen Komponente des Stufentransformators (3) kommunikativ verbunden ist, wobei das System folgende Merkmale aufweist:
• einen Aufnahmebereich (15), der zum Empfang der im Messgerät (2) gesammelten physikalischen Größen als Funktion der Zeit des mindestens einen Sensors (7₁, 7₂, ..., 7_{N}) ausgebildet ist;
• einen Datenaufbereitungsbereich (17), der eine Filterung der physikalischen Größen als Funktion der Zeit der mindestens einen Komponente des Stufentransformators (3) durchführt und aus den gefilterten Signalen eine hochaufgelöste Hüllkurve (20) erstellt, die einen Signalpegel (50) der physikalischen Größe der mindestens einen Komponente darstellt; und
• einen Datenanalysebereich (19), der eine erste Grenzwertkurve (54) und eine zweite Grenzwertkurve (56) bestimmt, deren Lage in Richtung einer Ordinate (O) veränderbar ist und die Werte der ersten Grenzwertkurve (54) einen Grenzwert darstellen,
• dass die erste Grenzwertkurve (54) und die zweite Grenzwertkurve (56) aufgrund von Hüllkurven (22) für nachfolgend gemessene physikalische Größen anhand der ersten Grenzwertkurve (54) und der zweiten Grenzwertkurve (56) für vorausgehend gemessene physikalische Größen aktualisiert werden, wobei die Werte der ersten Grenzwertkurve (54) einen Grenzwert darstellen und
• wobei zur Bestimmung der ersten und zweiten Grenzwertkurve
∘ aus der hochaufgelösten Hüllkurve (20) eine mittels Datenreduktion gewonnene Hüllkurve (22) erzeugt wird,
o die Hüllkurve (22) anhand einer Vielzahl von Stützstellen (21) ermittelt wird, die auf Basis der hochaufgelösten Hüllkurve (20) bestimmt werden
o die Hüllkurve dadurch ausgebreitet wird, dass in jede Stützstelle (21) eine Funktion (30) gesetzt wird **dadurch gekennzeichnet, dass**
o die Funktion (30), die in jede Stützstelle (21) der Hüllkurve (22) gesetzt wird eine nach unten geöffnete unsymmetrische Funktion (30), insbesondere eine nach unten geöffnete Parabel ist, die links schmäler als rechts ist.

2. System (1) nach Anspruch 1, wobei die mindestens eine Komponente ein Laststufenschalter mit einem Motorantrieb (9) zur Einstellung verschiedener Schaltpositionen des Laststufenschalters (5) ist, wobei der mindestens eine Sensor (7₁, 7₂, ..., 7_{N}) zur Erfassung von durch einen Laststufenschalter (5) im Schaltvorgang verursachte mechanische Schwingungen dient.

3. System (1) nach Anspruch 2, wobei der mindestens eine Sensor (7₁, 7₂, ..., 7_{N}) ein Beschleunigungssensor ist.

4. Verfahren zum Monitoring von mindestens einer Komponente eines Stufentransformators (3), wobei mindestens ein Sensor (7₁, 72, ..., 7_{N}) zur Erfassung physikalischer Größen als Funktion der Zeit vorgesehen ist, **gekennzeichnet durch** die folgenden Schritte:
- dass die physikalischen Größen von dem mindestens einen Sensor (7₁, 7₂,..., 7_{N}) von einem Messgerät (2) erfasst und vom Messgerät an einen Aufnahmebereich (15) eines Rechners (12) übertragen werden;
- dass in einem Datenaufbereitungsbereich (17) die erfasste physikalischen Größen gefiltert und in eine digitale, hochaufgelöste Hüllkurve (20) umgewandelt werden ;
- dass aus der hochaufgelösten Hüllkurve (20) eine mittels Datenreduktion gewonnen Hüllkurve (22) erzeugt wird,
- dass die Hüllkurve (22) anhand einer Vielzahl von Stützstellen (21) ermittelt wird, die auf Basis der hochaufgelösten Hüllkurve (20) bestimmt werden
- dass die Hüllkurve dadurch ausgebreitet wird, dass in jede Stützstelle (21) eine Funktion (30) gesetzt wird und
- die Funktion (30), die in jede Stützstelle (21) der Hüllkurve (22) gesetzt wird eine nach unten geöffnete unsymmetrische Funktion (30), insbesondere eine nach unten geöffnete Parabel ist, die links schmäler als rechts ist.
- dass in einem Datenanalysebereich (19) anhand der Hüllkurve (22) für jede physikalische Größe eine erste Grenzwertkurve (54) und eine zweite Grenzwertkurve (56) ermittelt werden;
- dass die erste Grenzwertkurve (54) und die zweite Grenzwertkurve (56) aufgrund von Hüllkurven (22) für nachfolgend gemessene physikalische Größen anhand der ersten Grenzwertkurve (54) und der zweiten Grenzwertkurve (56) für vorausgehend gemessene physikalische Größen aktualisiert werden, wobei die Werte der ersten Grenzwertkurve (54) einen Grenzwert darstellen.

5. Verfahren nach Anspruch 4, wobei die gemessene physikalische Größe der mindestens einen Komponente des Stufentransformators (3) einer Filterung unterzogen wird und die gefilterten physikalischen Größen in digitale Daten umgewandelt werden.

6. Verfahren nach Anspruch 5, wobei die Filterung eine Tiefpassfilterung der gemessenen und aufgezeichneten physikalischen Größen zur Vermeidung von Alias-Effekten durchgeführt wird, wobei die gefilterten physikalischen Größen in digitale Signale umgewandelt werden, die eine hochaufgelöste Hüllkurve (20) ergeben, und wobei auf die hochaufgelöste Hüllkurve (20) eine erneute Tiefpassfilterung angewendet und das gefilterte digitale Signal einer Datenreduzierung unterzogen wird.

7. Verfahren nach einem der Ansprüche 4 bis 6, wobei nach dem Ausbreiten der Hüllkurve (22) eine neue Berechnung der zweiten Grenzwertkurve (56) durchgeführt und wobei mit der neu berechneten zweiten Grenzwertkurve (56) eine Aktualisierung der Grenzwertkurven (54 ,56) durchgeführt wird.

8. Verfahren nach einem der Ansprüche 4 bis 6, wobei die mindestens eine Komponente des Stufentransformators (3) ein Laststufenschalter (5) ist, der zur Einstellung verschiedener Schaltpositionen des Stufentransformators (3) ausgebildet ist, dem Stufentransformator (3) ist ein Motorantrieb (9) zum Antrieb des Laststufenschalters (5) und mindestens ein Sensor (7₁, 7₂, ..., 7_{N}) zur Erfassung der von einem Schaltvorgang des Laststufenschalters (5) verursachten mechanischen Schwingungen zugeordnet.

9. Verfahren nach Anspruch 8 44 , wobei der mindestens eine Sensor (7₁, 7₂, ..., 7_{N}) ein Beschleunigungssensor ist, der das durch den einen Schaltvorgang des Laststufenschalter (5) verursachte Körperschallsignal als Funktion der Zeit aufzeichnet.

10. Computerprogramprodukt umfassend eine Vielzahl von Programmanweisungen, die bei Ausführung der Programmanweisungen durch ein System nach Anspruch 1, den Rechner (12) veranlassen die Schritte des Verfahrens nach einem der Ansprüche 4 bis 9 auszuführen.

## Claims

1. System (1) for recording physical variables of at least one component of a tap-changing transformer (3) and for monitoring the at least one component of the tap-changing transformer (3), comprising: at least one sensor (7₁, 7₂, ..., 7_{N}) for recording the physical variables of the at least one component of the tap-changing transformer (3) and having a computer (12) which is communicatively connected to a measuring device (2) which is communicatively connected to the at least one sensor (7₁, 7₂, ..., 7_{N}) for the purpose of receiving the physical variables of the at least one component of the tap-changing transformer (3), wherein the system has the following features:
• a receiving area (15) which is designed to receive the physical variables collected in the measuring device (2) as a function of the time of the at least one sensor (7₁, 7₂, ..., 7_{N});
• a data processing area (17) which filters the physical variables as a function of the time of the at least one component of the tap-changing transformer (3) and uses the filtered signals to create a high-resolution envelope curve (20) representing a signal level (50) of the physical variable of the at least one component; and
• a data analysis area (19) which determines a first limit value curve (54) and a second limit value curve (56), the position of which can be changed in the direction of an ordinate (O), wherein the values of the first limit value curve (54) represent a limit value,
• wherein the first limit value curve (54) and the second limit value curve (56) are updated on the basis of envelope curves (22) for subsequently measured physical variables using the first limit value curve (54) and the second limit value curve (56) for previously measured physical variables, wherein the values of the first limit value curve (54) represent a limit value, and
• wherein, in order to determine the first and second limit value curves,
o an envelope curve (22) obtained by means of data reduction is generated from the high-resolution envelope curve (20),
o the envelope curve (22) is determined using a multiplicity of supporting points (21) which are determined on the basis of the high-resolution envelope curve (20),
o the envelope curve is spread by setting a function (30) at each supporting point (21), **characterized in that**
o the function (30) which is set at each supporting point (21) of the envelope curve (22) is an asymmetrical function (30) which is open at the bottom, in particular a parabola which is open at the bottom and is narrower on the left than on the right.

2. System (1) according to Claim 1, wherein the at least one component is an on-load tap-changer having a motor-drive unit (9) for setting different switching positions of the on-load tap-changer (5), wherein the at least one sensor (7₁, 7₂, ..., 7_{N}) is used to record mechanical vibrations caused by an on-load tap-changer (5) in the switching operation.

3. System (1) according to Claim 2, wherein the at least one sensor (7₁, 7₂, ..., 7_{N}) is an acceleration sensor.

4. Method for monitoring at least one component of a tap-changing transformer (3), wherein at least one sensor (7₁, 7₂, ..., 7_{N}) for recording physical variables as a function of the time is provided, **characterized by** the following steps:
- the physical variables from the at least one sensor (7₁, 7₂, ..., 7_{N}) are recorded by a measuring device (2) and are transmitted from the measuring device to a receiving area (15) of a computer (12);
- in a data processing area (17), the recorded physical variables are filtered and are converted into a digital, high-resolution envelope curve (20);
- an envelope curve (22) obtained by means of data reduction is generated from the high-resolution envelope curve (20),
- the envelope curve (22) is determined using a multiplicity of supporting points (21) which are determined on the basis of the high-resolution envelope curve (20),
- the envelope curve is spread by setting a function (30) at each supporting point (21), and
- the function (30) which is set at each supporting point (21) of the envelope curve (22) is an asymmetrical function (30) which is open at the bottom, in particular a parabola which is open at the bottom and is narrower on the left than on the right,
- in a data analysis area (19), a first limit value curve (54) and a second limit value curve (56) are determined using the envelope curve (22) for each physical variable,
- the first limit value curve (54) and the second limit value curve (56) are updated on the basis of envelope curves (22) for subsequently measured physical variables using the first limit value curve (54) and the second limit value curve (56) for previously measured physical variables, wherein the values of the first limit value curve (54) represent a limit value.

5. Method according to Claim 4, wherein the measured physical variable of the at least one component of the tap-changing transformer (3) is subjected to filtering and the filtered physical variables are converted into digital data.

6. Method according to Claim 5, wherein the filtering is carried out as low-pass filtering of the measured and recorded physical variables in order to avoid alias effects, wherein the filtered physical variables are converted into digital signals which generate a high-resolution envelope curve (20), and wherein low-pass filtering is applied to the high-resolution envelope curve (20) again and the filtered digital signal is subjected to data reduction.

7. Method according to one of Claims 4 to 6, wherein after the envelope curve (22) has been spread, a new calculation of the second limit value curve (56) is carried out, and wherein the limit value curves (54, 56) are updated with the newly calculated second limit value curve (56).

8. Method according to one of Claims 4 to 6, wherein the at least one component of the tap-changing transformer (3) is an on-load tap-changer (5) which is designed to set different switching positions of the tap-changing transformer (3), and the tap-changing transformer (3) is assigned a motor-drive unit (9) for driving the on-load tap-changer (5) and at least one sensor (7₁, 7₂, ..., 7_{N}) for recording the mechanical vibrations caused by a switching operation of the on-load tap-changer (5).

9. Method according to Claim 8, wherein the at least one sensor (7₁, 7₂, ..., 7_{N}) is an acceleration sensor which records the structure-borne sound signal caused by one switching operation of the on-load tap-changer (5) as a function of the time.

10. Computer program product comprising a multiplicity of program instructions which, when the program instructions are executed by a system according to Claim 1, cause the computer (12) to carry out the steps of the method according to one of Claims 4 to 9.

## Revendications

1. Système (1) permettant de détecter des grandeurs physiques d'au moins un composant d'un transformateur à prises (3) et de surveiller ledit au moins un composant du transformateur à prises (3), comprenant : au moins un capteur (7₁, 7₂, ..., 7_{N}) servant à détecter les grandeurs physiques du au moins un composant du transformateur à prises (3), et comprenant un ordinateur (12) qui est relié en communication avec un appareil de mesure (2) qui est relié en communication audit au moins un capteur (7₁, 7₂, ..., 7_{N}) afin de recevoir les grandeurs physiques du au moins un composant du transformateur à prises (3), le système présentant les particularités suivantes :
• une zone d'enregistrement (15) qui est réalisée pour recevoir les grandeurs physiques collectées dans l'appareil de mesure (2) en fonction du temps du au moins un capteur (7₁, 7₂, ..., 7_{N}) ;
• une zone de traitement de données (17) qui effectue un filtrage des grandeurs physiques en fonction du temps dudit au moins un composant du transformateur à prises (3) et crée à partir des signaux filtrés une courbe enveloppe haute résolution (20) qui représente un niveau de signal (50) de la grandeur physique du au moins un composant ; et
• une zone d'analyse de données (19) qui détermine une première courbe de valeur limite (54) et une deuxième courbe de valeur limite (56) dont la position est variable en direction de l'ordonnée (O) et les valeurs de la première courbe de valeur limite (54) représentent une valeur limite,
• la première courbe de valeur limite (54) et la deuxième courbe de valeur limite (56) sont mises à jour sur la base de courbes enveloppes (22) pour des grandeurs physiques mesurées ultérieurement à l'aide de la première courbe de valeur limite (54) et de la deuxième courbe de valeur limite (56) pour des grandeurs physiques mesurées préalablement, les valeurs de la première courbe de valeur limite (54) représentant une valeur limite, et
• dans lequel, pour la détermination de la première et de la deuxième courbe de valeur limite
o une courbe enveloppe (22) obtenue au moyen d'une réduction de données est générée à partir de la courbe enveloppe haute résolution (20),
o la courbe enveloppe (22) est établie à l'aide d'une pluralité de points nodaux (21) qui sont déterminés sur la base de la courbe enveloppe haute résolution (20),
o la courbe enveloppe est étendue en ce qu'une fonction (30) est placée à chaque point nodal (21),
**caractérisé en ce que**
o la **fonction** (30) qui est placée à chaque point nodal (21) de la courbe enveloppe (22) est une fonction asymétrique (30) ouverte vers le bas, en particulier une parabole ouverte vers le bas qui est plus serrée à gauche qu'à droite.

2. Système (1) selon la revendication 1, dans lequel ledit au moins un composant est un changeur de prises en charge pourvu d'un entraînement de moteur (9) servant à régler différentes positions de changement du changeur de prises en charge (5), ledit au moins un capteur (7₁, 7₂, ..., 7_{N}) servant à détecter des oscillations mécaniques provoquées par un changeur de prises en charge (5) lors d'une opération de changement.

3. Système (1) selon la revendication 2, dans lequel ledit au moins un capteur (7₁, 7₂, ..., 7_{N}) est un capteur d'accélération.

4. Procédé permettant de surveiller au moins un composant d'un transformateur à prises (3), dans lequel au moins un capteur (7₁, 7₂, ..., 7_{N}) est prévu pour détecter des grandeurs physiques en fonction du temps, **caractérisé par** les étapes suivantes :
- les grandeurs physiques du au moins un capteur (7₁, 7₂, ..., 7_{N}) sont détectées par un appareil de mesure (2) et sont transmises de l'appareil de mesure à une zone d'enregistrement (15) d'un ordinateur (12) ;
- dans une zone de traitement de données (17), les grandeurs physiques détectées sont filtrées et converties en une courbe enveloppe numérique haute résolution (20) ;
- à partir de la courbe enveloppe haute résolution (20), une courbe enveloppe (22) obtenue au moyen d'une réduction de données est générée,
- la courbe enveloppe (22) est établie à l'aide d'une pluralité de points nodaux (21) qui sont déterminés sur la base de la courbe enveloppe haute résolution (20),
- la courbe enveloppe est étendue en ce qu'une fonction (30) est placée à chaque point nodal (21), et
- la fonction (30) qui est placée à chaque point nodal (21) de la courbe enveloppe (22) est une fonction asymétrique (30) ouverte par le bas, en particulier une parabole ouverte par le bas, qui est plus serrée à gauche qu'à droite,
- dans une zone d'analyse de données (19), à l'aide de la courbe enveloppe (22), une première courbe de valeur limite (54) et une deuxième courbe de valeur limite (56) sont établies pour chaque grandeur physique ;
- la première courbe de valeur limite (54) et la deuxième courbe de valeur limite (56) sont mises à jour sur la base de courbes enveloppes (22) pour des grandeurs physiques mesurées ultérieurement à l'aide de la première courbe de valeur limite (54) et de la deuxième courbe de valeur limite (56) pour des grandeurs physiques mesurées préalablement, les valeurs de la première courbe de valeur limite (54) représentant une valeur limite.

5. Procédé selon la revendication 4, dans lequel la grandeur physique mesurée du au moins un composant du transformateur à prises (3) est soumise à un filtrage et les grandeurs physiques filtrées sont converties en données numériques.

6. Procédé selon la revendication 5, dans lequel le filtrage effectue un filtrage passe-bas des grandeurs physiques mesurées et enregistrées afin d'éviter des repliements de spectre, les grandeurs physiques filtrées étant converties en signaux numériques qui produisent une courbe enveloppe haute résolution (20), et dans lequel, un nouveau filtrage passe-bas est appliqué à la courbe enveloppe haute résolution (20), et le signal numérique filtré est soumis à une réduction de données.

7. Procédé selon l'une quelconque des revendications 4 à 6, dans lequel, après avoir étendu la courbe enveloppe (22), un nouveau calcul de la deuxième courbe de valeur limite (56) est effectué, et dans lequel, avec la deuxième courbe de valeur limite (56) nouvellement calculée, une mise à jour des courbes de valeur limite (54, 56) est effectuée.

8. Procédé selon l'une quelconque des revendications 4 à 6, dans lequel ledit au moins un composant du transformateur à prises (3) est un changeur de prises en charge (5) qui est réalisé pour régler différentes positions de changement du transformateur à prises (3), un entraînement de moteur (9) servant à entraîner le changeur de prises en charge (5) et au moins un capteur (7₁, 7₂, ..., 7_{N}) servant à détecter les oscillations mécaniques provoquées par ledit un changement du changeur de prises en charge (5) sont associés au transformateur à prises (3).

9. Procédé selon la revendication 8, dans lequel ledit au moins un capteur (7₁, 7₂, ..., 7_{N}) est un capteur d'accélération qui enregistre le signal de bruit de structure en fonction du temps, provoqué par une opération de changement du changeur de prises en charge (5) .

10. Produit de programme informatique comprenant une pluralité d'instructions de programme qui, lorsque les instructions de programme sont exécutées par un système selon la revendication 1, font que l'ordinateur (12) exécute les étapes du procédé selon l'une quelconque des revendications 4 à 9.
